# EUROPEAN PATENT APPLICATION

(11) **EP 4 703 956 A1**
(43) Date of publication of application: **04.03.2026**
(21) Application number: 24465564.3
(22) Date of filing: 28.08.2024
(51) Int. Cl.: G06F 30/27, G06F 30/3308, G06N 20/00

(54) **METHOD TO PREPARE A VERIFICATION PROJECT, A METHOD TO CONDUCT A VERIFICATION PROJECT A COMPUTER PROGRAM PRODUCT, A COMPUTER-READABLE STORAGE MEDIUM AN INTEGRATING SYSTEM AND A MACHINE LEARNING CLUSTER**

(71) Applicant: Siemens Aktiengesellschaft, 80333 München (DE)
(72) Inventor: BANCIU, Nicolae-Alexandru, 500096 Brasov (RO); HEGHI, Andreea Gabriela, 500171 Brasov (RO); GHEORGHE, Stefan, 100456 Ploiesti, Prahova (RO)
(74) Representative: Fierascu, Cosmina-Catrinel

(57) **Abstract**

The invention relates to a method to prepare a verification project in a verification system, the method comprising the following steps: Processing verification artefacts by an integrating system, Configuring a machine learning cluster by the integrating; Configuring a function call management unit of the hybrid verification environment by the integrating system
- Instantiating a system under test of the verification project in the hybrid verification environment by the integrating system; Configuring a decision management unit for the verification project in the hybrid verification environment by the integrating system, the decision management unit comprising a definition of processes to be accomplished in the verification project; and Configuring the prompt design module to translate function call management and the selected ai models in the machine learning cluster for the verification project.

## Description

The present invention relates to a method to prepare a verification project, a method to conduct a verification project a computer program product, a computer-readable storage medium an integrating system and a machine learning cluster.

One of the most important steps in Digital ICs (Integrated Circuits) design (applicable in both ASIC - Application Specific Integrated Circuits design and FPGA-based design) is the Functional Verification, which ensures the intended functionality is correctly implemented and there are no hidden, undetected, functional errors left in the design.

The functional verification is performed in the design phase of the future IC and makes use of either simulation (simulation-based verification) or formal methods (formal verification).

While formal verification uses EDA (Electronic Design Automation) SW tools to mathematically prove the correctness, the simulation-based methods use simulators (EDA tools) together with dedicated testing constructs grouped in verification environments (testbenches). Testbenches are implemented using dedicated Hardware Verification Languages (like SystemVerilog, e, or even higher level languages like SystemC) or using the same Hardware Description Languages which are used to implement the design itself (like VHDL or Verilog).

To address the constant increase of design size and complexity, several techniques (like coverage driven verification, constrained-random stimulation, direct testing, assertion-based verification, etc.) and methodologies (like UVM - Universal Verification Methodology) were introduced during time to facilitate, automate, reuse and increase the confidence level of the functional verification. Reaching a high confidence level (all functionalities are implemented and are functionally correct) translates (according to the mentioned techniques and methodologies) into achieving a high functional coverage level (as close as possible to 100%). Verified functionalities must be correctly and complete linked to requirements, specifications and verification plans.

In the first steps, the verification intents are defined. Starting with the specifications (detailed description of the main technical aspects, requirements and functionality) one must spend a significant amount of time in order to correlate simulation data with the corresponding specification items.

The above-mentioned techniques and methodologies were created to speed-up and to automate the functional verification process. With different verification language constructs, the verification environments can flexibility generate (during simulation process) the stimuli (the input patterns) for the design under test (DUT, also named system under test - system under test). Other language constructs allow collection of coverage data (which reveal how much of the verification intents were exercised during simulations). A significant effort and time must be spent to create appropriate verification environments, capable to create and propagate stimuli to design (or its internal modules) inputs, to analyze the simulated design responses, to appropriately report errors and the measured coverage level.

Even for environments with a high degree of automation, during simulation several on-the-fly actions are often needed. Such actions might be analyzing data on the fly, make predictions for module outputs based on simulated inputs or even compare different design states against specifications. These actions take a lot of time and require a big effort for developing the verification infrastructure (infrastructure which must implement in the hardware verification language of choice - all the needed verification features).

Design specification or requirements may change during the verification process, requiring the readjustments of the verification environment. These changes can introduce additional complexity and unscheduled delays, time which is aimed to be shortened using more flexible techniques.

Another time and effort consuming activity is debugging. Whenever an incorrect functionality is encountered, a detailed analysis (debug) is performed to examine the incorrect behavior (which might be an incorrect design behavior, an incorrect behavior of the verification environment or an inconsistency in the specifications). Moreover, effort is spent often to debug and solve issues already encountered in previous (with a high degree of similarity) implementations, increasing thus the effort with unnecessary actions.

Reaching a very high degree of verification coverage (as the size and the complexity increases) becomes thus more and more difficult to achieve. On the other hand, incomplete verification increases risks associated with the verification process (increasing the probability ofnundetected design functional errors at any of the module, IP or system level).

In order to decrease the level of uncertainty, the number of simulations must be increased (verification engineers use more and more parallel simulations, trying to increase the simulation space) or they may even make use of Emulators to cover more of the simulation space. This increase of the simulation effort increases the overall verification costs (more EDA tools licenses, additional costs for compute infrastructure or for emulation infrastructure).

In general, simulation-based design functional verification requires significant computational resources. Very often the simulation ends into an error caused by the misunderstanding of the specification or the presence of a flaw in the verification testbench, and the simulation process is restarted. Also, large simulation time is caused by simulation the complex verification components/frameworks, not by simulating the system under test (system under test) itself. There is thus a constant need to improve the functional verification techniques and methodologies, innovating in either the verification constructs usage, in automatic generation of flexible environments or in the EDA tools support for the verification process. There is a need to create means to address the specifications more closely, to create verification constructs with less human intervention, to have on-the-fly access to internal states of the simulation, to reduce overall simulation time and effort, etc.

On-the-fly modifications (or adaptions) of the verification environment structure are not straightforward, in many cases there are even impossible to be realized. There are different approaches to use Artificial Intelligence/Machine Learning (Artificial Intelligence/Machine Learning) for verification purposes, yet these approaches are addressing data processing and decisions based on simulation results (large simulation data which is already available). The simulation-based verification uses the EDA simulators and process the verification constructs. The verification environments implemented using hardware design languages or hardware verification languages are internally processed by the EDA tools. For this reason, implementation of Artificial Intelligence/Machine Learning algorithms directly in the verification environments cannot be performed. Or, if they can still be implemented to some extent, the simulation loop must remain active (the simulation cannot be ended) to allow continuous reinforcement of the internal AI structures.

Existing design verification approaches use different simulation-based techniques (e.g. coverage driven verification, constrained-random stimulation, direct testing, assertion-based verification, etc. ) or formal analysis techniques. There are dedicated and widely adopted design and verification languages (VHDL, Verilog, SystemVerilog, SystemC) that can be interfaced with other programming languages. Methodologies like UVM allow fast creation of reusable verification components and environments. The created environments are compiled and executed by EDA simulators. In some cases, external precompiled sources, implemented in another, higher level language can be executed (with inline calls from the verification environments). Such functionality is provided through procedural interfaces, e.g. Verilog Procedural Interface (VPI) which allows interfacing with C precompiled functions or SystemVerilog Direct Programming Interface (SystemVerilog DPI) which allows interfacing with C, C++, SystemC or other languages. The verification constructs or components follow predefined structures (as they are defined by the verification methodologies, like UVM) and there is a relative low flexibility in re-shaping these predefined structures (or their behavior). The external, precompiled functionalities which are called through the procedural interfaces are used to fast provide fast results for different (often high compute) operations. Reference functionalities (full implementation of reference models or just some parts of them) are sometimes implemented using other languages (like C, C++ or SystemC), they are precompiled and then load as shared objects by the simulators. Whenever the fast response to some inputs to those functionalities are needed, the precompiled functions are called (via VPI or DPI) and the results are collected by the simulator.

The use of Artificial Intelligence/Machine Learning techniques in hardware verification is still in early stages of development. Some of the efforts explore the use of machine learning in certain verification tasks such as testbench code generation, regressions analysis, bug detection, verification artifacts processing, etc. Different Artificial Intelligence/Machine Learning solutions are thus under development to provide support in functional verification. The newly introduced Generative AI methodologies based on LLMs (Large Language Models) and NLP (Natural Language Processing) create an interaction with the user (the Verification Engineer), supporting him in the verification process (e.g. by providing code examples or even by constructing parts of the environment, by being a companion and guiding in the verification tasks definition, etc.).

It is an object of the present invention to provide a solution to embed artificial intelligence/machine learning techniques in hardware verification.

This objective is achieved by the respective subject matter of the independent claims. Further implementations and preferred embodiments are subject matter of the dependent claims.

A first aspect of the present invention relates to a method to prepare a verification project.

The method comprises the following steps. A step comprises processing verification artefacts by an integrating system. The verification artefacts define the verification project comprising verification goals to verify a system under test.

A next step comprises configuring a machine learning cluster by the integrating system according to the verification artefacts. The configuring comprises a selection and a preparation of selected ai models of the machine learning cluster for the verification project.

A next step comprises configuring a function call management unit of the hybrid verification environment by the integrating system. The configuring of the function call management unit comprises a compilation of functions in the function call management to interact with the selected ai models for the verification project, provided in the machine learning cluster.

A next step comprises instantiating a system under test of the verification project in the hybrid verification environment by the integrating system. In other words, the system under test, described in the verification artefacts, that is to be verified in the verification project is instantiated in the hybrid verification environment.

A next step comprises configuring a decision management unit for the verification project in the hybrid verification environment by the integrating system. The configuring of the decision management unit comprises a defining of processes to be accomplished in the verification project.

A next step comprises configuring a prompt design module to translate function call management and the selected ai models in the machine learning cluster for the verification project. In other words, in the verification project, the function call management unit is configured to provide function calls to request requested data from the ai models. The function call management unit also provides simulation data from a simulation of the system under test necessary to fulfil the request by the ai model. To request the requested data from the ai model, a corresponding prompt has to be provided to the ai model. The prompt design module translates the function calls and the corresponding simulation data to a respective prompt for the ai model. The step comprises the configuration of the prompt design module to configure the prompt design module to provide the prompts for the selected ai models.

At the end of the method, the framework is prepared to conduct the verification project on the system under test.

According to a further aspect of the present invention, the method comprises a step of receiving verification documents by the integrating system. In other words, the verification documents are provided to the integrating system. The verification documents may comprise specifications of the system under test, a verification plan or other documents describing the verification or the system under test. A next steps comprises an extracting of the verification artefacts from the verification documents by the integrating system. The integrating system may use LLMs to interpret the verification documents and to extract the verification artefacts from the documents.

According to a further aspect of the present invention, the ai models comprise at least one ai model specialized in design and verification artefact processing.

According to a further aspect of the present invention, the ai models comprise at least one ai model specialized in failure analysis.

According to a further aspect of the present invention, the ai models comprise at least one ai model specialized in stimuli generation and/or stimuli validation.

According to a further aspect of the present invention, the ai models comprise at least one ai model specialized in output prediction.

A second aspect of the present invention relates to a method to conduct a verification project prepared in a method according to the first aspect of the present invention. The method comprises the following steps.

A first step comprises a setting of a current verification goal of the verification project by the integrating system. In other words, the current verification goal to be achieved in a simulation is set by the integrating system.

A next step comprises a starting of the simulation of the verification project in the hybrid environment by the integrating system. In other words, the simulation on the system under test in the hybrid verification environment is initiated to achieve the current verification goal of the verification project.

A next step comprises an evaluation of a current state of the simulation of the verification project by the integrating system. In other words, at least once during the simulation, the current state of the simulation is analyzed.

A next step comprises proving by the hybrid verification environment, whether in the current state of the simulation, requested data from the selected ai models of the verification project in the machine learning cluster are needed. In other words, the hybrid verification environment analyzes the current state to determine, whether requested data must be provided to the simulation. The requested data are data that have to be provided by the selected ai models, that where configured for the verification project in the machine learning cluster.

The next step depends on the result of the previous step. If the hybrid verification environment detects, that the requested data from the selected ai models are needed, the hybrid verification environment packs simulation data of the simulation necessary for the requested data. The hybrid verification environment further selects the function call necessary for the requested data by the hybrid verification environment. In other words, the hybrid verification environment prepares the simulation data to be provided to the ai model and the respective function call.

In a next step, the hybrid verification environment provides a request, comprising the function call and the simulation data to the prompt design module. In other words, the hybrid verification environment requests the requested data by sending the request to the prompt design module.

A next step comprises translating the request comprising the simulation data and the function call to a respective prompt for the corresponding ai model in the hybrid verification environment by the prompt design module. In other words, to request the requested data from the ai modell, the request is translated to a corresponding prompt by the prompt design module. The translation depends on the ai model, that is assigned to the function call in the prompt design module. The simulation data may be converted to input data for the ai model.

A next step comprises sending the respective prompt to the corresponding ai model in the machine learning cluster by the prompt design module. In other words, the prompt design module sends the prompt to the machine learning cluster, wherein the prompt is assigned to the ai module linked to the respective function call.

A next step comprises a receiving of a response, comprising the requested data, from the ai model by the hybrid verification environment. In other words, the ai model receives the prompt and performs the request using the simulation data. After that, the ai model sends the requested data in a corresponding response to the hybrid verification environment. The hybrid verification environment receives the response and reads the requested data from the response.

A next step comprises providing the requested data to the simulation by the hybrid verification environment. In other words, the hybrid verification environment imports the requested data to the simulation.

The method further comprises a proceeding with the simulation of the verification project until a predefined verification target is achieved. In other words, the hybrid verification environment continues the simulation. The hybrid verification environment ends the simulation, when the verification target is achieved.

A third aspect of the invention is related to a computer program product comprising program code for performing a method according to the first aspect of the present invention and/or the second aspect of the present invention. The computer program product may also be regarded as a computer program.

A fourth aspect of the invention is related to a computer-readable storage medium comprising at least the computer program product according to the third aspect of the present invention.

A fifth aspect of the invention is related to an integrating system, configured to perform the steps of a method according to the according to the first aspect of the present invention and/or the second aspect of the present invention, performed by the integration system.

A sixth aspect of the invention is related to a machine learning cluster, configured to perform the steps of a method according to the according to the first aspect of the present invention and/or the second aspect of the present invention, performed by the machine learning cluster.

The integrating system and the machine learning cluster may comprise computing devices to perform steps of the methods.

A computing device may in particular be understood as a data processing device, which comprises processing circuitry. The computing device may therefore in particular process data to perform computing operations. This may also include operations to perform indexed accesses to a data structure, for example a look-up table, LUT.

In particular, the computing device may include one or more computers, one or more microcontrollers, and/or one or more integrated circuits, for example, one or more application-specific integrated circuits, ASIC, one or more field-programmable gate arrays, FPGA, and/or one or more systems on a chip, SoC. The computing device may also include one or more processors, for example one or more microprocessors, one or more central processing devices, CPU, one or more graphics processing devices, GPU, and/or one or more signal processors, in particular one or more digital signal processors, DSP. The computing device may also include a physical or a virtual cluster of computers or other of said devices.

In various embodiments, the computing device includes one or more hardware and/or software interfaces and/or one or more memory devices.

A memory device may be implemented as a volatile data memory, for example a dynamic random access memory, DRAM, or a static random access memory, SRAM, or as a non-volatile data memory, for example a read-only memory, ROM, a programmable read-only memory, PROM, an erasable read-only memory, EPROM, an electrically erasable read-only memory, EEPROM, a flash memory or flash EEPROM, a ferroelectric random access memory, FRAM, a magnetoresistive random access memory, MRAM, or a phase-change random access memory, PCRAM.

Independent of the grammatical term usage, individuals with male, female or other gender identities are included within the term.

Further features of the invention are apparent from the claims, the figures and the figure description. The features and combinations of features mentioned above in the description as well as the features and combinations of features mentioned below in the description of figures and/or shown in the figures may be comprised by the invention not only in the respective combination stated, but also in other combinations. In particular, embodiments and combinations of features, which do not have all the features of an originally formulated claim, are also comprised by the invention. Moreover, embodiments and combinations of features which go beyond or deviate from the combinations of features set forth in the recitations of the claims are comprised by the invention.

In the following, the invention will be explained in detail with reference to specific exemplary implementations and respective schematic drawings. In the drawings, identical or functionally identical elements may be denoted by the same reference signs. The description of identical or functionally identical elements is not necessarily repeated with respect to different figures.

In the figures,
FIG 1 shows a schematic illustration of an integrating system and a machine learning cluster;
FIG 2 shows a schematic illustration of a method to prepare a verification procedure;
FIG 3 shows a schematic illustration of a method to conduct a verification procedure;
FIG 4 shows a schematic illustration of phases of a verification project according to the state of the art; and
FIG 5 shows a schematic illustration of phases of a verification project.

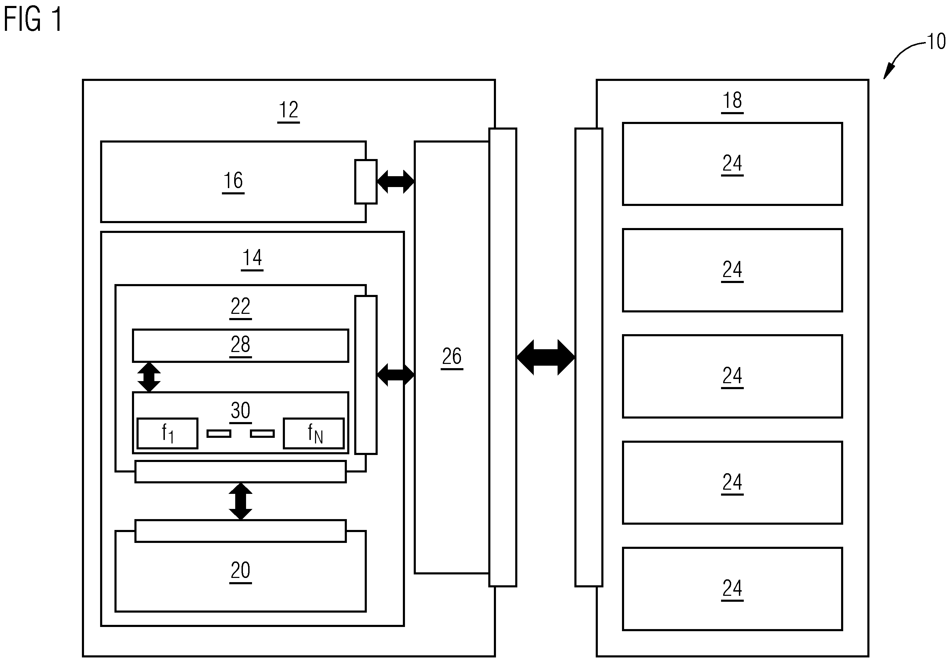

FIG 1 shows a schematic illustration of an integrating system and a machine learning cluster

The proposed method addresses a Framework that automatically interconnects the verification environments and verification artifacts using precompiled functionalities which target different verification goals to external computational capabilities which use Artificial Intelligence/Machine Learning techniques.

The main component of the Framework is the Integrating system 12 that has the capability to supervise and orchestrate the whole verification process. Its main functionalities are provided by specialized blocks that interconnects the Hybrid Verification Environment 14 and Verification Artefacts 16 with a Machine Learning Cluster 18.

The Hybrid Verification Environment 14 comprises the System Under Test 20 and the Conductor Unit 22 which implements the other components used for verification.

The Machine Learning Cluster 18 is a virtual environment which has the capability to connect to multiple AI Models 24 (. The AI models 24 can be either Machine Leaning Models or Large Language Models for language-based tasks. Each AI model 24 is specialized and tasked with a certain functionality. Several AI models 24 can address the same functionality or there can be combinations (several AI models 24 addressing the same functionalities and other AI models 24 addressing separate, distinctive functionalities).

An example where distinctive functionalities are connected to the Integrating System 12 through the machine learning cluster 18 is presented in FIG 1. The machine learning cluster 18 is a virtual environment which connects different AI models 24 to the Integrating System 12. The AI models 24 can be totally separated (e.g. from different solution providers, running on different infrastructures, can have different sizes and capabilities, etc.).

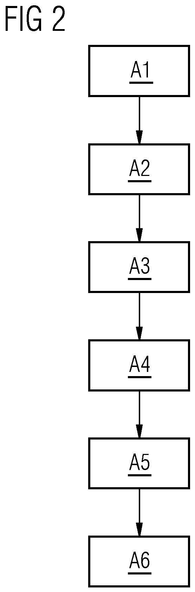

In the case where at least two of the AI models 24 are addressing the same functionality (as exemplified in FIG 2), the provided results can be used for different purposes inside the Integrating System 12. Such purposes can be, for instance, for comparison, for correctness analysis, or for any other purpose. For instance, the provided results (from the different AI models 24 which address the same or similar functionality) can be used to compare the performance in a chosen metric (e.g. stimuli coverage, simulation time) for a specific task between multiple approaches. The integrating system 12 can then choose the most suitable responses for the current verification target. The same mechanism can be used for ensuring the correctness of the simulation (e.g. use a majority vote approach to select the stimuli for the system under test 20 or estimate and predict the system under test 20 outputs).

Another component of the Integrating System 12 is represented by the Verification Artifacts considered in the current verification process. These are information extracted from different documents (such as Specifications, Requirements or Verification Plans, etc.) and are used to direct and measure the verification process.

In order to connect the whole verification process to an machine learning cluster 18 (which uses different AI models 24), the Integrating System 12 contains a component which implements a communication scheme with the machine learning cluster 18. This component, named Prompt Design Unit 26 (prompt design unit 26), is managing API calls with predefined templates to be filled with different information related to the verification process (e.g. simulation data), retrieves specialized instructions related to the verification process and translate the received data into the format required by the verification process.

In comparison to a traditional verification environment, the hybrid verification environment 14 enables the shifting of the complexity to external. The main functionalities of a testbench (stimuli generation, result prediction etc.) can be transformed into simple, straightforward function calls to external computational resources, the AI models 24.

Conductor Unit 22 has a component, the Decision Management Unit 28 which controls the internal state of the whole verification system 10 and selects which functions to be called and information requests to be sent to the machine learning cluster 18.

The proposed method comprises of multiple components that can be grouped into one of the following categories, considering their main functionalities:
Integrating system 12 - Overarching architecture that contains all the verification-related structures:
   Verification Artifacts - Comprising of, but not limited to, design specifications, verification plans, verification metadata.
Hybrid verification environment 14 - the basic structure of a traditional verification environment, enhanced with the ML interfacing infrastructure:
   Conductor Unit 22 - decision block that orchestrates the hybrid verification environment 14-ML interactions based on on-the-fly simulation data and the context provided by verification artifacts.
   System Under Test 20 - design to be verified (usually comprising of a hardware description language implementation).
   Prompt design unit 26 - based on the input from the conductor unit 22 the appropriate ML algorithm is queried, and the generated result is routed back inside the simulation.

Machine Learning Cluster 18 - multiple Artificial Intelligence Models specialized for different functions such as data retrieval, stimuli generation, output prediction.

FIG 2 shows a schematic illustration of a method to prepare a verification procedure.

The method may involve the elements shown in FIG 1. The method to prepare the verification procedure may comprise the following steps.

A step A1 may comprise a processing of verification artefacts 16 by an integrating system 12. The verification artefacts 16 may define the verification project comprising verification goals to verify a system under test 20.

A step A2 may comprise a configuring of a machine learning cluster 18 by the integrating system 12 according to the verification artefacts 16. The step may comprise a selection and a preparation of selected ai models 24 for the verification project.

A step A3 may comprise a configuring of a function call management unit 30 of the hybrid verification environment 14 by the integrating system 12. The step may comprise a compilation of functions in the function call management to interact with the selected ai models 24 for the verification project, provided in the machine learning cluster 18 in step A2.

A step A5 may comprise an instantiating of a system under test 20 of the verification project in the hybrid verification environment 14 by the integrating system 12.

A step A6 may comprise a configuring of a decision management unit 28 for the verification project in the hybrid verification environment 14 by the integrating system 12. The step may comprise a defining of processes to be accomplished in the verification project.

A step A7 may comprise a configuring of a prompt design module to translate function call management and the selected ai models 24 in the machine learning cluster 18 for the verification project.

In other words, the proposed method may comprise the following main steps :
A1: Process verification artifacts (specification, verification plan) - Adding predefined annotations, creating search indexes for the LLMs, feature engineering for simulation metadata.
A2: machine learning cluster 18 configuration - based on the defined verification targets a selection is made from the suite of available specialized machine learning models.
A3: Configure the function call management unit 30 inside the hybrid verification environment 14- compile the required functions (configure the function call management unit 30) used for interacting with the AI models 24, functions that encapsulate the simulation data.
A4: Instantiate system under test 20 in the hybrid verification environment 14.
A5: Configure the decision management unit 28 inside the hybrid verification environment 14 - define the processes that need to be accomplished based on the system under test 20 or simulation state, considering the simulation goals.
A6: prompt design unit 26 configuration - Fill the predefined LLM prompt templates and ML input templates and feed the algorithm response back to the simulation.

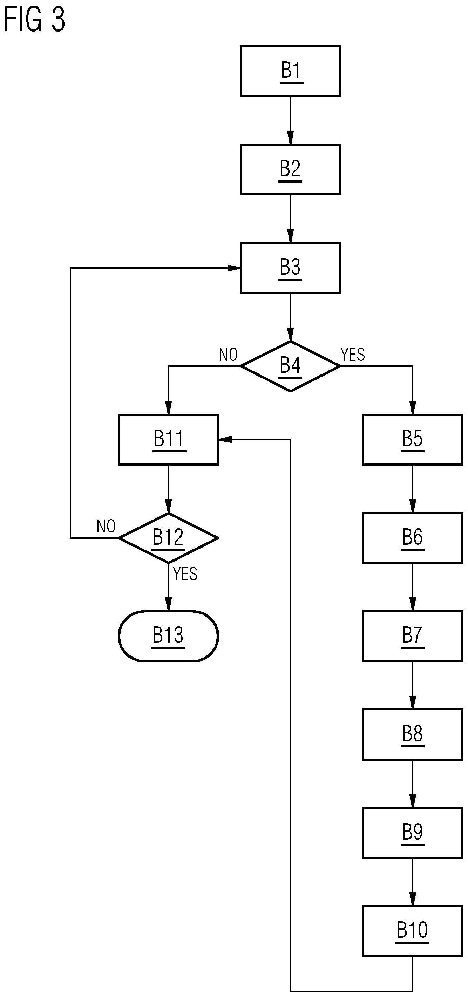

FIG 3 shows a schematic illustration of a method to conduct a verification procedure.

The method may comprise a step B1 of setting a current verification goal of the verification project by the integrating system 12.

A step B2 may comprise a starting of a simulation of the verification project in the hybrid verification environment 14 by the integrating system 12.

A step B3 may comprise an evaluating of a current state of the simulation of the verification project by the hybrid verification environment 14.

A step B4 may comprise a proving by the hybrid verification environment 14, whether in the current state of the simulation, requested data from the selected ai models 24 of the verification project in the machine learning cluster 18 are needed.

If the data from the selected ai models 24 are needed, a next step B5 may comprise packing simulation data of the simulation necessary for the requested data and selecting a function call necessary for the requested data by the hybrid verification environment 14.

A step B6 may comprise providing a request, comprising the function call and the simulation data to the prompt design module by the hybrid verification environment 14.

A step B7 may comprise translating the request comprising the simulation data and the function call to a respective prompt for the corresponding ai model 24 in the hybrid verification environment 14 by the prompt design module.

A step B8 may comprise a sending of the respective prompt to the corresponding ai model 24 in the machine learning cluster 18 by the prompt design module;

A step B9 may comprise a receiving of a response, comprising the requested data, from the ai model 24 by the hybrid verification environment 14.

A step B10 may comprise a providing of the requested data to the simulation by the hybrid verification environment 14.

The method may continue proceeding with the simulation of the verification project until a predefined verification target is achieved B11.

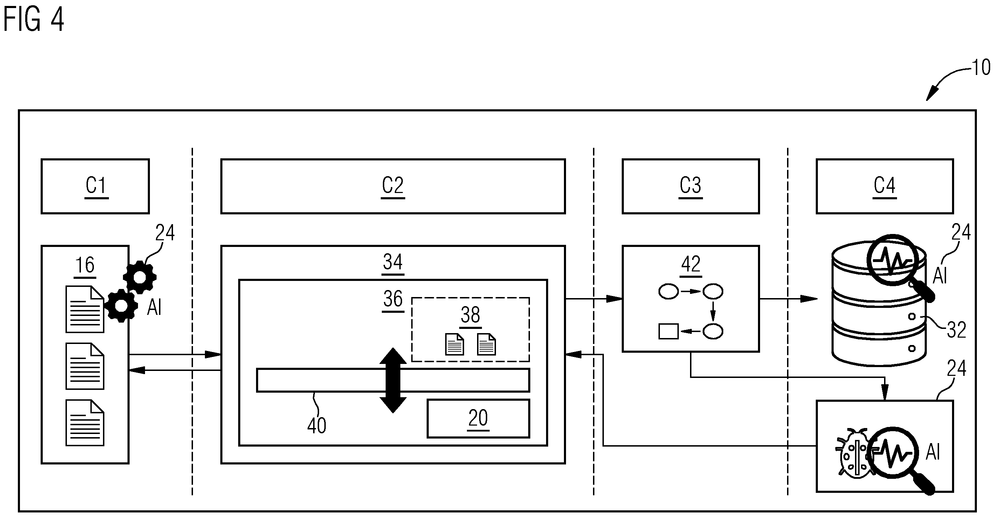

FIG 4 shows a schematic illustration of phases of a verification project according to the state of the art.

The functional verification is performed in the design phase of the future IC and makes use of either simulation (simulation-based verification) or formal methods (formal verification).

While formal verification uses EDA (Electronic Design Automation) SW tools to mathematically prove the correctness, the simulation-based methods use simulators (EDA tools) together with dedicated testing constructs grouped in verification environments (testbenches). Testbenches are implemented using dedicated Hardware Verification Languages (like SystemVerilog, e, or even higher level languages like SystemC) or using the same Hardware Description Languages which are used to implement the design itself (like VHDL or Verilog).

To address the constant increase of design size and complexity, several techniques (like coverage driven verification, constrained-random stimulation, direct testing, assertion-based verification, etc.) and methodologies (like UVM - Universal Verification Methodology) were introduced during time to facilitate, automate, reuse and increase the confidence level of the functional verification. Reaching a high confidence level (all functionalities are implemented and are functionally correct) translates (according to the mentioned techniques and methodologies) into achieving a high functional coverage level (as close as possible to 100%). Verified functionalities must be correctly and complete linked to requirements, specifications and verification plans.

In the first steps, the verification intents are defined. Starting with the specifications (detailed description of the main technical aspects, requirements and functionality) one must spend a significant amount of time in order to correlate simulation data with the corresponding specification items.

The above-mentioned techniques and methodologies were created to speed-up and to automate the functional verification process. With different verification language constructs, the verification environments can flexibility generate (during simulation process) the stimuli (the input patterns) for the design under test (DUT, also named system under test 20 - system under test 20). Other language constructs allow collection of coverage data (which reveal how much of the verification intents were exercised during simulations). A significant effort and time must be spent to create appropriate verification environments, capable to create and propagate stimuli to design (or its internal modules) inputs, to analyze the simulated design responses, to appropriately report errors and the measured coverage level.

Even for environments with a high degree of automation, during simulation several on-the-fly actions are often needed. Such actions might be analyzing data on the fly, make predictions for module outputs based on simulated inputs or even compare different design states against specifications. These actions take a lot of time and require a big effort for developing the verification infrastructure (infrastructure which must implement in the hardware verification language of choice - all the needed verification features).

Design specification or requirements may change during the verification process, requiring the readjustments of the verification environment. These changes can introduce additional complexity and unscheduled delays, time which is aimed to be shortened using more flexible techniques.

Another time and effort consuming activity is debugging. Whenever an incorrect functionality is encountered, a detailed analysis (debug) is performed to examine the incorrect behavior (which might be an incorrect design behavior, an incorrect behavior of the verification environment or an inconsistency in the specifications). Moreover, effort is spent often to debug and solve issues already encountered in previous (with a high degree of similarity) implementations, increasing thus the effort with unnecessary actions.

Reaching a very high degree of verification coverage (as the size and the complexity increases) becomes thus more and more difficult to achieve. On the other hand, incomplete verification increases risks associated with the verification process (increasing the probability ofnundetected design functional errors at any of the module, IP or system level).

In order to decrease the level of uncertainty, the number of simulations must be increased (verification engineers use more and more parallel simulations, trying to increase the simulation space) or they may even make use of Emulators to cover more of the simulation space. This increase of the simulation effort increases the overall verification costs (more EDA tools licenses, additional costs for compute infrastructure or for emulation infrastructure).

In general, simulation-based design functional verification requires significant computational resources. Very often the simulation ends into an error caused by the misunderstanding of the specification or the presence of a flaw in the verification testbench, and the simulation process is restarted. Also, large simulation time is caused by simulation the complex verification components/frameworks, not by simulating the system under test 20 (system under test 20) itself.

There is thus a constant need to improve the functional verification techniques and methodologies, innovating in either the verification constructs usage, in automatic generation of flexible environments or in the EDA tools support for the verification process. There is a need to create means to address the specifications more closely, to create verification constructs with less human intervention, to have on-the-fly access to internal states of the simulation, to reduce overall simulation time and effort, etc.

On-the-fly modifications (or adaptions) of the verification environment structure are not straightforward, in many cases there are even impossible to be realized. There are different approaches to use Artificial Intelligence/Machine Learning (Artificial Intelligence/Machine Learning) for verification purposes, yet these approaches are addressing data processing and decisions based on simulation results (large simulation data which is already available). The simulation-based verification uses the EDA simulators and process the verification constructs. The verification environments implemented using hardware design languages or hardware verification languages are internally processed by the EDA tools. For this reason, implementation of Artificial Intelligence/Machine Learning algorithms directly in the verification environments cannot be performed. Or, if they can still be implemented to some extent, the simulation loop must remain active (the simulation cannot be ended) to allow continuous reinforcement of the internal AI structures.

Existing design verification approaches use different simulation-based techniques (e.g. coverage driven verification, constrained-random stimulation, direct testing, assertion-based verification, etc. ) or formal analysis techniques. There are dedicated and widely adopted design and verification languages (VHDL, Verilog, SystemVerilog, SystemC) that can be interfaced with other programming languages. Methodologies like UVM allow fast creation of reusable verification components and environments. The created environments are compiled and executed by EDA simulators. In some cases, external precompiled sources, implemented in another, higher level language can be executed (with inline calls from the verification environments). Such functionality is provided through procedural interfaces, e.g. Verilog Procedural Interface (VPI) which allows interfacing with C precompiled functions or SystemVerilog Direct Programming Interface (SystemVerilog DPI) which allows interfacing with C, C++, SystemC or other languages. The verification constructs or components follow predefined structures (as they are defined by the verification methodologies, like UVM) and there is a relative low flexibility in re-shaping these predefined structures (or their behavior). The external, precompiled functionalities which are called through the procedural interfaces are used to fast provide fast results for different (often high compute) operations. Reference functionalities (full implementation of reference models or just some parts of them) are sometimes implemented using other languages (like C, C++ or SystemC), they are precompiled and then load as shared objects by the simulators. Whenever the fast response to some inputs to those functionalities are needed, the precompiled functions are called (via VPI or DPI) and the results are collected by the simulator.

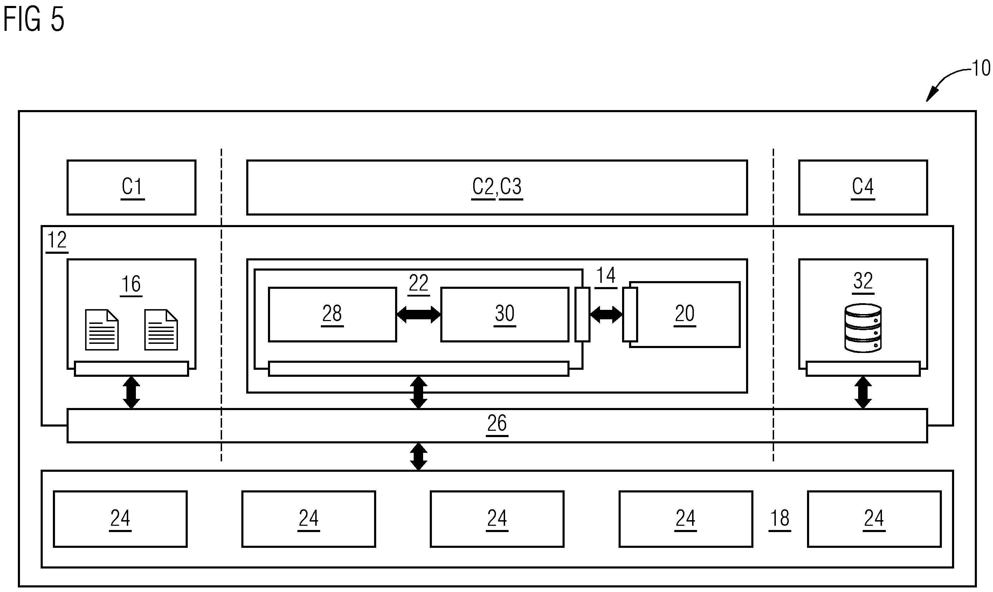

FIG 5 shows a schematic illustration of phases of a verification project.

The novelty of the proposed resides in the capability to automatically integrate multiple parallel (specialized on different or similar functionalities) Artificial Intelligence Models in the hardware verification flow. Remove the "Node" processing limitation by shifting the complexity to a AI model 24, by moving entire functionality of complex environment components to simple/straightforward function calls that are less time-consuming, and less "node-dependent" resource consuming.

The proposed method allows automatic transmission between the hardware verification framework and the AI models 24 by using predefined structures, templates and algorithms designed specifically for hardware verification.

### List of Reference

- 10: verification system
- 12: integrating system
- 14: hybrid verification environment
- 16: verification artefacts
- 18: machine learning cluster
- 20: system under test
- 22: conductor unit
- 24: AI model
- 26: prompt design unit
- 28: decision management unit
- 30: function call management unit
- 32: verification results
- 34: verification environment design
- 36: simulation based verification
- 38: ai generated code
- 40: DPI/VPI
- 42: simulation
- A1-A6: steps of method to prepare a verification project
- B1-B13: steps of method to conduct a verification project
- C1: verification planing phase
- C2: testbench designing phase
- C3: simulation phase
- C4: result analysis and debugging phase

## Claims

1. Method to prepare a verification project in a verification system (10), the method comprising the following steps:
- processing verification artefacts (16) by an integrating system (12), the verification artefacts (16) defining the verification project comprising verification goals to verify a system under test (20);
- configuring a machine learning cluster (18) by the integrating system (12) according to the verification artefacts (16), comprising a selection and a preparation of selected ai models (24) for the verification project;
- configuring a function call management unit (30) of the hybrid verification environment (14) by the integrating system (12), comprising a compilation of functions in the function call management to interact with the selected ai models (24) for the verification project, provided in the machine learning cluster (18);
- Instantiating a system under test (20) of the verification project in the hybrid verification environment (14) by the integrating system (12);
- configuring a decision management unit (28) for the verification project in the hybrid verification environment (14) by the integrating system (12), the decision management unit (28) comprising a definition of processes to be accomplished in the verification project; and
- configuring the prompt design module to translate function call management and the selected ai models (24) in the machine learning cluster (18) for the verification project.

2. Method according to claim 1, comprising the step of
- receiving verification documents by the integrating system (12); and
- extracting the verification artefacts (16) from the verification documents by the integrating system (12)

3. Method according to any one of the preceding claims, wherein the ai models (24) comprise at least one ai model (24) specialized in design and verification artefact processing.

4. Method according to any one of the preceding claims, wherein the ai models (24) comprise at least one ai model (24) specialized in failure analysis.

5. Method according to any one of the preceding claims, wherein the ai models (24) comprise at least one ai model (24) specialized in stimuli generation and/or stimuli validation.

6. Method according to any one of the preceding claims, wherein the ai models (24) comprise at least one ai model (24) specialized in output prediction.

7. Method to conduct a verification project prepared in a method according to any one of the preceding claims in a verification system (10), the method comprising the following steps:
- setting a current verification goal of the verification project by the integrating system (12);
- starting a simulation of the verification project in the hybrid verification environment (14) by the integrating system (12),
- evaluating a current state of the simulation of the verification project by the hybrid verification environment (14);
- proving by the hybrid verification environment (14), whether in the current state of the simulation, requested data from the selected ai models (24) of the verification project in the machine learning cluster (18) are needed;
- if the data from the selected ai models (24) are needed, packing simulation data of the simulation necessary for the requested data and selecting a function call necessary for the requested data by the hybrid verification environment (14),
- providing a request, comprising the function call and the simulation data to the prompt design module by the hybrid verification environment (14);
- translating the request comprising the simulation data and the function call to a respective prompt for the corresponding ai model (24) in the hybrid verification environment (14) by the prompt design module;
- sending the respective prompt to the corresponding ai model (24) in the machine learning cluster (18) by the prompt design module;
- receiving a response, comprising the requested data, from the ai model (24) by the hybrid verification environment (14);
- providing the requested data to the simulation by the hybrid verification environment (14); and
- proceeding with the simulation of the verification project until a predefined verification target is achieved.

8. A computer program product comprising program code for performing a method according to any one of the preceding claims 1 to 6 and/or according to claim 7.

9. A computer-readable storage medium comprising at least the computer program product according to claim 8.

10. Integrating system, configured to perform the steps of a method according to any one of the preceding claims performed by the integration system.

11. Machine learning cluster, configured to perform the steps of a method according to any one of the preceding claims performed by the machine learning cluster.
